# EUROPEAN PATENT SPECIFICATION

(11) **EP 0 573 645 B1**
(45) Date of publication and mention of the grant of the patent: **01.04.1998**
(21) Application number: 93902757.9
(22) Date of filing: 23.12.1992
(51) Int. Cl.: C23C 16/30, C23C 16/40, C23C 16/06, C23C 16/08, B32B 18/00, B32B 9/04, C04B 35/12, C04B 35/03

(54) **METHOD FOR COATING A SURFACE WITH A RESISTANT FACING BY CHEMICAL-VAPOR DEPOSITION**
VERFAHREN ZUR BESCHICHTUNG EINER OBERFLÄCHE MIT EINER WIDERSTANDSFÄHIGEN SCHICHT MITTELS CVD
METHODE PERMETTANT DE REVETIR UNE SURFACE D'UNE COUCHE RESITANTE PAR PROCEDE CHIMIQUE EN PHASE GAZEUSE

(30) Priority: 26.12.1991 US 814367
(43) Date of publication of application: 15.12.1993
(73) Proprietor: ELF ATOCHEM NORTH AMERICA, INC., Philadelphia Pennsylvania 19102-3222 (US)
(72) Inventor: BUCHANAN, Jerome, Lawrence, Easton, PA 18042 (US); DIRKX, Ryan, Richard, Glenmoore, PA 19343 (US)
(74) Representative: Kraus, Walter, Dr.
(86) International application number: US9211213
(87) International publication number: WO9313243

(56) References cited:
- EP-A- 0 256 822
- US-A- 3 898 672
- US-A- 4 077 808
- US-A- 4 194 994
- US-A- 4 668 528
- US-A- 4 671 993
- US-A- 4 743 506
- US-A- 4 873 115
- US-A- 4 971 843
- US-A- 5 112 693
- US-A- 5 132 165
- JOURNAL OF VACUUM SCIENCE & TECHNOLOGY A, vol. 4, no. 6, 1 December 1986 WOODBURY, NY, USA, page 2706 EVA FREDRIKSSON ET AL. 'Chemical vapor deposition of titanium oxides'
- THIN SOLID FILMS, vol. 198, no. 1/2, 20 March 1991 LAUSANNE, CH, pages 317-329, F. KEITH PERKINS ET AL. 'CHROMIUM OXIDE FILMS FABRICATED BY Cr(CO)6 CHEMICAL VAPOR DEPOSITION'
- JOURNAL OF MATERIALS SCIENCE, vol. 24, no. 1, 1 January 1989 LONDON,GB, pages 192-198, YASUTAKA TAKAHASHI ET AL. 'Preparation of VO2 films by organometallic chemical vapour deposition and dip-coating'
- THIN SOLID FILMS, vol. 206, no. 1/2, 10 December 1991 LAUSANNE, CH, pages 102-106, SUN-OO KIM ET AL. 'The effect of substrate temperature on the composition and growth of tantalum oxide thin films deposited by plasma-enhanced chemical vapour deposition'

## Description

*Field of the Invention.* This invention is in the field of improving the wear- and chemical-resistant characteristics of materials by providing a resistant surface coating. More particularly, the present invention is in the field of applying a wear-resistant, and generally hard, metal-oxide or other facing by deposition of a coating from the vapor phase.

*Description of the Prior Art.* Materials chosen for engineering functions necessarily have mechanical characteristics suitable for the applications for which they are selected; these materials include, e.g., glass, aluminum, steel, brass, and a wide variety of polymers. However, it is rare that a particular material has optimal characteristics for all of the operational parameters to which the particular item or part will be subjected. Thus, some modification to the base material may be required to provide optimal working characteristics for the finished item.

For instance, a plastic part can be metal-coated by vacuum sputtering, to furnish a conductive, reflective or decorative surface not inherent in the base material, and a pump housing or reciprocating-engine block may be formed of cast iron, aluminum, or steel for strength, but because the wear-resistance characteristics in the cylinder area are rarely adequate, some modification has to be made for that purpose.

In cast-iron and aluminum engine blocks specifically, it is common to provide an insert cylinder sleeve of, e.g., hard alloy steel in which the piston travels and against which the piston rings bear, both for acceptable wear life of the unit and for operating efficiency resulting from the relatively low sliding friction between the matching parts. The same principle holds true for the combustion-chamber wall and the apex seal in rotary engines.

In the matter of combustion engines, the heat-transfer characteristics of the structural components are also of importance; if the engine operating temperature is maintained at too low a temperature, operating efficiency suffers, and exhaust emissions increase. From the viewpoint of net energy efficiency, the hotter the engine is able to run, the lower is the requirement to discard parasitic heat, and the greater is the engine efficiency. However, if the interface between a piston ring and the cylinder wall becomes too hot, the lubricant film can thin out and permit seizing and galling of the respective surfaces, with concomitant rapid increase of wear and decrease of the effective operational life of the engine.

One approach to the problem of increasing the operational temperature of a combustion engine has been to make a cylinder with a hard, refractory and corrosion-resistant surface having a low coefficient of friction against which the piston ring runs in juxtaposition to that surface. A method known in the present art is that of applying an aqueous solution of a chromium salt to a cylinder wall, and thereafter heating the wall to drive off the water and to convert the salt to Cr₂O₃. An engine thus treated is capable of running at higher temperatures than is an untreated one, with a resultant improvement in operating efficiency.

The method of coating by the application of a solution of a chromium salt is effective for the purpose described here, but may require more than ten repetitions of the steps of applying the solution and subsequent heating. As a result, the process is relatively labor-intensive, time-consuming and costly.

Methods of vapor-phase deposition, known also as chemical-vapor deposition (CVD) of hard materials are known in the art. Stemmler, et al., in US 4,525,389, describe the coating of a workpiece by a volatile chromium compound and steam. In US 4,310,567, Tasata, et al., disclose the deposition of a material on a heated substrate by directing a stream of the material or its precursor onto the substrate under conditions where coating or reaction occurs at the substrate surface.

In British patent 1,408,294, there is described at page 3, lines 100 et seq., the deposition of a Cr₂O₃ coating on a cemented carbide cutting tool by the oxidation of a halogenated chromium compound.

Powell, et al., in *Vapor Deposition,* (John Wiley & Sons, New York, 1966; p. 402), have reported that codeposition of boric and chromic oxides improved adhesion and cohesion, but provided a coating with some solubility in water.

In the described prior art, however, no system has yet produced a functional wear- or chemical-, and specifically corrosion-resistant, coating with acceptable economics.

### SUMMARY OF THE INVENTION

The present invention is a method for the chemical vapor deposition of a mixed metal oxide coating on a substrate selected from brass, bronze, aluminum, cast iron, castable and stainless steel, and titanium at atmospheric or higher pressure to provide a wear-resistant coating on the substrate, wherein the metal oxide coating is selected from the group consisting of a mixture of at least two oxides selected from the group consisting of oxides of aluminum, cadmium, chromium, cobalt, germanium, indium, iridium, molybdenum, nickel, tin, tantalum, titanium, tungsten, vanadium, zinc and zirconium, said method comprising treating said substrate at a temperature above 400°C with a gaseous mixture at atmospheric or higher pressure comprising a carrier fluid in gaseous form, a source of oxygen and at least two precursors of the metal oxide coating, to cause deposition of the metal oxides on the substrate; with the proviso that at least one of the metal oxides is derived from nickel, tin, titanium, vanadium or zirconium.

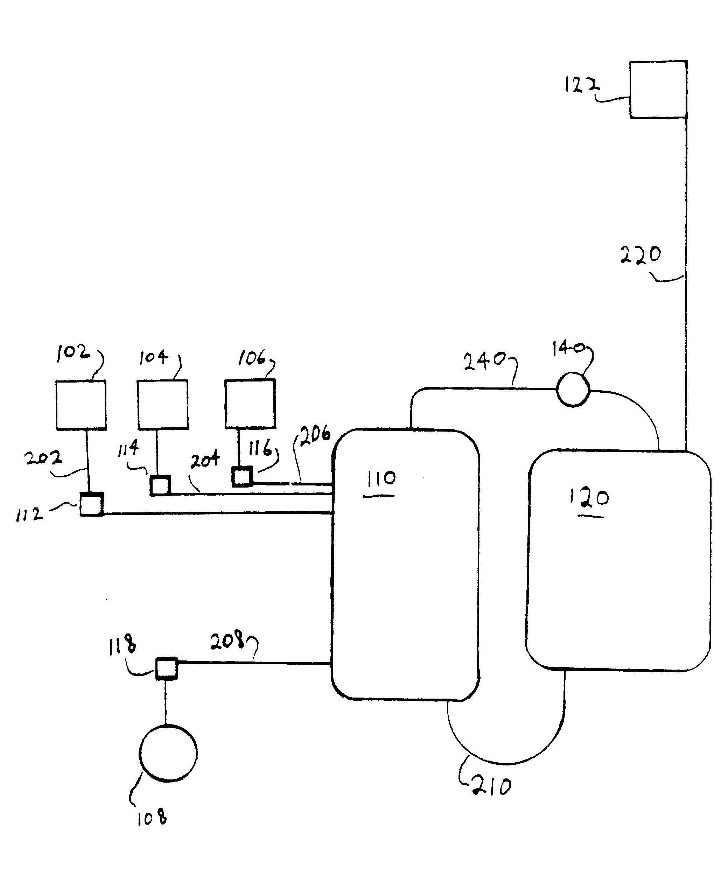

### BRIEF DESCRIPTION OF THE DRAWING

The drawing figure shows a schematic representation of the process of the invention.

### DISCUSSION OF THE INVENTION

This invention is a method of coating a substrate with a hard or wear-resistant material, which comprises treating the substrate surface, at a temperature high enough to provide reaction or decomposition on that surface, with a mixture of at least one precursor of that material, and at least one accelerant, in the presence of a source of oxygen, to cause formation of the hard material. A gaseous carrier fluid is used to transport materials to the substrate surface.

Wear-resistant materials useful in this invention, termed "hard materials" for the purposes of this specification, comprise hard metal compounds selected from mixed oxides.

The reaction of the precursor takes place with an oxygenating substance; the oxides are formed at or near, and deposited on, the substrate surface by reaction of a precursor of the hard material.

A carrier fluid such as air serves to transport reagents to the substrate surface, and to remove reaction products and unreacted reagents.

Precursors for deposition include metal compounds generally which are capable of reacting to provide the desired material on the substrate surface. Precursors useful in the present invention include, e.g., compounds of aluminum, cadmium, chromium, cobalt, germanium, indium, iridium, molybdenum, nickel, tantalum, titanium, tungsten, vanadium, zinc and zirconium. Preferred precursors are chromium, titanium and tungsten compounds.

Compounds from which the hard materials of this invention can be deposited include, e.g., aluminum alkyls and alkoxides, cadmium alkyls, chromyl chloride, germanium halides and alkoxides, nickel alkyls and carbonyl, indium alkyls, titanium alkoxides and halides, tungsten oxychloride, vanadium halides, zinc alkyls, zirconium alkoxides, and mixtures thereof. Specific examples of such compounds include, e.g., Al(C₂H₅)₃, CrO₂Cl₂, GeBr₄, Ti(OC₃H₇)₄, TiCl₄, TiBr₄, Ti(C₆H₉O₂)₄, Zr(OC₅H₁₁)₄, Ni(CO)₄, VCl₄, Zn(CH₃)₂, WOCl₃ and mixtures of these materials. Preferred compounds are chromyl chloride, titanium alkoxides and halides, and tungsten oxychloride.

Those skilled in the art will understand that precursors discussed in this specification must be sufficiently volatile, alone or with other materials, and sufficiently stable under the process conditions, to be a part of the composition from which the desired hard materials are deposited.

A preferred hard material of this invention comprises chromium oxide, deposited from a precursor mixture containing chromyl chloride.

The CVD coating process of this invention comprises treating the substrate with a gaseous mixture of at least one precursor of the hard material and a co-reagent, and optionally an accelerant, and removing reaction by-products and unreacted materials, whereby the hard material is formed by reaction or decomposition of the precursor and the co-reagent at the substrate surface so treated. "Co-reagent," as used herein, means a material which, in combination with the precursor, provides a deposited hard material on the substrate under the conditions of deposition. For the purposes of this specification, an "accelerant" is defined as a material whose presence in the system serves to increase the rate of deposition of the hard material onto the substrate; i.e., a rate which is greater than has heretofore been achieved in commercial practice.

The accelerant may also serve as a co-reagent, to provide a deposit comprising oxides of the constituent metals; thus, the composition of the gaseous mixture at or near the substrate can comprise the precursor and a co-reagent in the carrier fluid, or it can comprise the precursor, a co-reagent and an accelerant in the carrier fluid. Where the co-reagent serves also as an accelerant, the composition can then comprise two or more components in addition to the carrier fluid.

Materials useful as either or both co-reagents and deposition-rate accelerants include tin, titanium, nickel, vanadium and zirconium compounds and mixtures thereof; as heretofore noted, such materials must also be sufficiently volatile to provide an adequate quantity of material at the substrate surface for CVD of the desired coating. Illustrative examples of accelerants and co-reagents include SnCl₄, SnBr₄, SnI₄, (CH₃)₂SnCl₂, (CH₃)₃SnCl, (C₂H₅)₃SnH, (C₆H₅)₂SnCl₂, (C₂H₅)₂SnCl₂, (C₄H₉)SnCl₃, TiCl₄, TiBr₄, Ti(C₆H₉O₂)₄, Ti(OC₃H₇)_{4,} Ni(CO)₄, VCl₄, and mixtures of these materials. Preferred compounds include SnCl₄, (CH₃)₃SnCl, MBTC, TiCl₄, Ti(OC₃H₇)_{4,} and Ni(CO)_{4.}

Those skilled in the art will recognize that the carrier fluid will most probably be in the gaseous phase in the vicinity of the substrate surface, due to the elevated temperature in that region. The carrier fluid preferably has an oxygenating capability, but can be any material capable of transporting the precursor, co-reagent and accelerant, or any of them, to the reaction site, and is gaseous under the process conditions.

The carrier fluid can be a substance selected from the group consisting of air, nitrogen, oxygen, CO₂, water, noble gases, and mixtures thereof.

Oxygenation of the precursor can be effected by supplying a source of oxygen, either as such or in air, or in a material having oxygen in the molecule, wherein the material has the formula RₘC(OR'ₙ)ₚ, where R and R' are independently chosen from hydrogen; substituted and unsubstituted straight, cyclic, or branched-chain alkyl or alkenyl of from one to about six carbons; phenyl, substituted phenyl, or R"CH₂CH₂-, where R" is MeO₂C-, EtO₂C-, CH₃CO-, or HO₂C-, *m* is 1, 2 or 3, *n* is zero or 1, and *p* is 1 or 2, provided that *m + p* cannot exceed 4.

The source of oxygen can be selected from the group consisting of alcohols with from 1 to about 8 carbons, aldehydes and ketones with from 1 one to about 8 carbons, and ethers, esters and acid anhydrides with from 1 to about 6 carbons in each moiety of the molecule.

Those skilled in the art will realize that the coating produced in accordance with this invention can also provide resistance to general chemical and corrosive attack on the coated surface.

Coating effected by this invention comprises deposition onto a substrate from a composition of at least one volatile compound of a metal precursor of the hard material, an accelerant, a co-reagent or both, in a molar ratio of from 0.1-1/0.1-1/0.1-1, the composition being mixed in a carrier fluid at from about 0.05 to about 1 molar, and applied to a substrate at a temperature above 400 degrees Celsius (°C).

### DESCRIPTION OF THE PREFERRED EMBODIMENTS

A preferred embodiment of the present invention is the CVD coating of a substrate with a refractory or wear-resistant material. More preferably, this invention comprises the deposition of the refractory or wear-resistant material onto the substrate surface from a gaseous mixture of at least one precursor of the material and an accelerant, and removing reaction by-products and unreacted materials, where during at least the deposition step, the surface of the substrate is maintained at an effective temperature high enough to cause decomposition of the precursor on or near the substrate surface, i.e., by direct heating of the substrate, or by plasma deposition. Alternatively, the temperature of the precursor or mixture of precursor, co-reagent and accelerant can be established in a manner to cause decomposition of the mixture at or near the substrate surface. In normal plant practice, the process comprises the steps of separating reaction products and unreacted materials, and recycling the unreacted materials.

Most preferably, the components of the present invention comprise a volatile chromium compound and a co-reagent gas selected from the group consisting of at least one volatile tin or titanium compound, or mixtures of those compounds, and an accelerant, deposited onto a substrate at an elevated temperature; the accelerant is optionally oxygenating, and a carrier fluid is used as a vehicle. The accelerant and the carrier can, in some embodiments, be the same material; further, combinations of accelerants are within the scope of this invention. Deposition is carried out at, or above atmospheric pressure.

A preferred embodiment of this invention comprises a hard coating formed by deposition onto a substrate from a composition of at least one volatile compound of a metal precursor of the hard material, an accelerant, a co-reagent or both, in a molar ratio of from 0.1-1/0.1-1/0.1-1, the composition being mixed in a carrier fluid at from about 0.05 to about 1 molar, and applied to a substrate at a temperature above 400°C.

The most-preferred embodiment of the invention comprises the composition CrO₂Cl₂, methyl isobutyl ketone (MIBK) and monobutyltintrichlorids (MBTC) in a molar ratio of 1:1:1 applied from a gaseous solution of 0.2 mol percent of the 1:1:1 mixture in dry air at a flow rate of about 25 standard liters per minute (SLM), at a gas velocity of from about 0.1 to about 10 meters per second, to a substrate maintainted at a temperature of from about 600 to about 700°C. For the purposes of this specification, the term "volatile compound" is chosen to mean a compound having a vapor pressure high enough to permit its conversion to the vapor phase without significant decomposition in the course of the process described herein; the vapor pressure can be a partial pressure in association with another material, such as can be obtained with steam- or other co-distillation.

The coating can also be applied by the use of precursor materials having relatively low volatility by entraining them in carrier-fluid streams. The carrier fluid is gaseous. The composition of the coating is a mixture of chromium and tin oxides, and can be a solid solution which is either crystalline or amorphous to x-rays.

In the drawing figure, apparatus for effecting CVD of an exemplary hard material in accordance with this invention comprises containers **102** for the precursor of the refractory substance deposited, **104** for the accelerant, and **106** for a co-reagent if used. Transport lines **202, 204** and **206** convey the respective materials through suitable mass-flow meters **112, 114** and **116** to vaporizer **110**. Carrier fluid is also conveniently measured by meter **118** from source **108** through transport line **208** into vaporizer **110**. Source **108** can include, e.g., compressed air, steam or nitrogen, bottled CO₂ and the like.

Transport line **210** carries the mixture of reagents, co-reagents and carrier fluid to reactor **120**; that reactor has means, not shown but well known to those skilled in the art, for establishment and maintenance of an elevated temperature above 400 degrees Centigrade (°C). The reagents, upon encountering heated substrate surfaces either in reactor **120** or on articles contained therewithin, react to form a hard coating, optionally admixed with compounds, typically oxides, of e.g., tin or titanium.

Transport line **220** serves to convey waste products from the reaction in reactor **120** to waste-treatment means **122**. Treatment means **122** is conveniently a scrubber or other device serving to keep deleterious materials from being exhausted into the atmosphere. Duct **240** and blower **140** are provided to recycle reagents and carrier gas if desired to improve the overall efficiency of the process.

Although one application of the process of this invention is generally sufficient to provide the desired coating thickness, the application can be repeated as often as desired in order to build up successive layers, to insure that no uncoated areas remain on the substrate, or to provide a specified thickness, as the process or product may require.

In an illustration of the utility of the present invention, a single-cylinder cast-iron diesel-engine block is prepared by acid-etching the cylinder, rinsing it with tap water, and then drying it, preferably by heating. The cylinder, as reactor **120**, is then connected to transport line **210** with gas-tight fittings known to those skilled in the art. Chromyl chloride, CrO₂Cl₂, from container **102**, is admixed in the vapor phase in vaporizer **110** with MIBK from container **104** and with MBTC from container **106**, and air from source **108**, each of the gases being conducted through its respective transport line. The gaseous mixture from vaporizer **110** is then caused to pass over the surface of the cylinder **120**, maintained at 450°C. An oxidation reaction occurs at the heated surface of the cylinder to deposit a layer of mixed chromium and tin oxides approximately **20** micrometers (µm) in thickness. Reaction by-products and unreacted materials are removed through transport line **220** to waste-treatment means **122**.

Compounds useful in the method of the present invention are precursors of the hard material whose vapor pressures, alone or in admixture with other materials, are adequate to provide a useful quantity of refractory or wear-resistant material at the surface of the article to be treated; such materials are within the broad range of metal compounds which provide hard materials upon reaction under the CVD process conditions.

Combinations of accelerants are within the scope of this invention; thus, a gaseous mixture containing, e.g., both MBTC and Ni(CO)₄has utility in the CVD of a hard coating on, e.g., a steel or cast-iron.

From the description of the invention, those skilled in the art will now also realize that the coating method and materials taught herein are applicable to a variety of substrates selected from brass, bronze, aluminum, cast iron, castable and stainless steel, and titanium.

Those skilled in the art will further understand that the surface of a given substrate must generally be prepared prior to the coating method set forth here, and that the preparation may vary with the material being treated or the nature of the coating.

One embodiment of this invention comprises CrO₂Cl₂, MIBK, and MBTC being applied from a gaseous solution of 0.2 mole percent in dry air at atmospheric pressure to a substrate having a surface temperature of from about 600 to about 700 °C.

The utility of this invention is demonstrated by the following examples.

### Example 1

A cast-iron cylinder liner is prepared by acid-etching, rinsing and then drying. The liner is heated to a temperature between 400 and 650°C and allowed to come to thermal equilibrium. The heated surface is then treated by passing CrO₂Cl₂, admixed in the vapor phase with MIBK, MBTC and air, over that surface. An oxidation reaction occurs at the heated surface of the cylinder to deposit a layer of mixed chromium and tin oxides approximately 25 µm in thickness.

### Example 2

The surface of the cylinder liner of Example 1 is prepared by anodically etching, followed by a water rinse and then drying. The liner is heated to a temperature between 400 and 650°C and allowed to come to thermal equilibrium. CrO₂Cl₂, admixed in the vapor phase with MIBK, MBTC and air, is then caused to pass over the heated surface. An oxidation reaction occurs at the heated surface of the cylinder to deposit a layer of mixed chromium and tin oxides approximately 25 nm in thickness.

### Example 3

A 3.2 millimeter (mm)-thick by 32 mm-diameter disk of cast iron is anodically etched and then heated in air at 700°C for 20 minutes (min). The substrate is subsequently placed in a reactor whose temperature is such that the substrate temperature is 625°C. A 1:1:1 molar mixture of chromyl chloride, MIBK, and MBTC at 0.2 mol percent of the mixture in dry air is vaporized and caused to impinge upon the surface at 40 SLM for 25 min. An adherent coating of about 25µm in thickness is obtained.

The substrate is allowed to cool, and is analyzed. The coating is found to consist of chromium oxide and tin oxides.

### Example 4

A 3.2 mm-thick by 32 mm-diameter disk of cast iron is plated with chromium. The sample is oxidized in a furnace at 750°C. Subsequently, the disk is placed on a nickel block heated to 650°C. Coating vapors as described in example 3, maintained at 100°C, are passed over the surface of the substrate, whereby the process results in a deposit as discussed in reference to examples 2 and 3.

### Example 5

A 3.2 mm-thick by 32 mm-diameter disk of brass is liquid-honed and heated in air. The substrate is coated by the application of a gaseous mixture as in example 3; the coating temperature of 550°C provides a deposit as in example 3.

### Example 6

A gaseous mixture consisting of nitrogen, MIBK and chromyl chloride is passed over a stainless-steel substrate prepared as in Example 5. The temperature of the substrate is 625°C. The resulting coating is smooth, hard and adherent.

### Example 7

A 95 mm x 540 mm cast-iron substrate is anodically etched and heated to 500°C in air. A gas-phase composition as in Example 3 is passed over the substrate. The sample is wear-tested against zirconia, and found to impart significant wear resistance to the cast iron by reducing the wear rate by a factor of about 30.

Those skilled in the art will realize that proper pretreatment of the surface is necessary to secure the optimum adherence of the coating to the substrate, and that the step of anodically etching the cylinder walls set forth above is only exemplary. Other methods could include, e.g., electroless or electrolytic deposition of a preplate material, acid washing, surface ablation, and the like.

### Example 8

A 3.2 mm-thick by 32 mm-diameter disk of cast iron is prepared as in Example 3. A 1:1:1 molar mixture of Cr(NO₃)₃·7½H₂O, SnCl₄ and propyl pentanoate at 0.2 mol percent of the mixture in dry air is vaporized and impinged upon the surface at 40 SLM for 25 min. Analysis shows an adherent coating of about 20 µm in thickness, consisting of chromium and tin oxides.

### Example 9

The surface of the cylinder liner of Example 1 is prepared by anodically etching, followed by a water rinse and then drying. The liners are heated to a temperature between 400 and 650°C and allowed to come to thermal equilibrium. CrO₂Cl₂, admixed in the vapor phase with MIBK, Ti(C₅H₇O₂)₄, and air, is then caused to pass over the heated surface. An oxidation reaction occurs at the heated surface of the cylinder to deposit a layer of mixed chromium and titanium oxides approximately 25 µm in thickness.

### Examples 10 through 25

A 3.2 mm-thick by 32 mm-diameter disk of cast iron is prepared as in Example 3. A 1:1:1 molar mixture of a metal compound, a co-reagent and an oxygen-containing compound at 0.2 mol percent of the mixture in a dry carrier gas is vaporized and caused to impinge upon the surface at 40 SLM for 25 min. Adherent coatings from about 20 to about 30µm in thickness are obtained; the coatings contain mixtures of oxides of the metals used in the example.

| Example No. | Metal Compound | Co-Reagent | Oxygen-Containing Compound | Carrier Gas |
|---|---|---|---|---|
| 10 | Cr(CO)₃ | SnCl₄ | CH₃OH | air |
| 11 | Zr(C₅H₁₁O)₄ | SnBr₄ | C₂H₅OH | N₂ |
| 12 | CrO₂Cl₂ | SnI₄ | C₃H₅OH | CO₂ |
| 13 | Ti(OC₃H₇)₄ | (CH₃)₂SnCl₂ | C₈H₁₆O | air |
| 14 | Zr(C₅H₁₁O)₄ | (CH₃)₃SnCl | C₃H₆O | He |
| 15 | Ni(CO)₄ | (C₂H₅)₃SnH | (C₂H₅)₂O | H₂O |
| 16 | VCl₄ | (C₆H₅)₂SnCl₂ | (C₅H₉)₂O | air |
| 17 | Co(CH₃)₃ | (C₂H₅)₂SnCl₂ | (C₆H₅)₂O | N₂ |
| 18 | Cr(CO)₃ | TiCl₄ | C₃H₇OCH₃ | N₂ |
| 19 | Cr₂(SO₄)₃ | TiBr₄ | (C₅H₇O)OCH₃ | air |
| 20 | Ti(OC₃H₇)₄ | Ti(C₆H₉O₂)₄ | (C₂H₃O)OC₂H₅ | H₂O |
| 21 | Zr(C₅H₁₁O)₄ | Ti(OC₃H₇)₄ | C₆H₅O(OCH) | CO₂ |
| 22 | Ni(CO)₄ | Zr(OC₅H₁₁)₄ | (C₂H₃O)₂O | Ar |
| 23 | VCl₄ | Ni(CO)₄ | (C₄H₇O)₂O | MBTC |
| 24 | Ti(OC₃H₇)₄ | VCl₄ | (C₆H₁₁O)₂O | MIBK |
| 25 | WOCl₄ | MBTC | MIBK | air |

## Claims

1. A method for the chemical vapor deposition of a mixed metal oxide coating on a substrate selected from brass, bronze, aluminum, cast iron, castable and stainless steel, and titanium at atmospheric or hiqher pressure to provide a wear-resistant coating on the substrate, wherein the metal oxide coating is selected from the group consisting of a mixture of at least two oxides selected from the group consisting of oxides of aluminum, cadmium, chromium, cobalt, germanium, indium, iridium, molybdenum, nickel, tin, tantalum, titanium, tungsten, vanadium, zinc and zirconium, said method comprising treating said substrate at a temperature above 400°C with a gaseous mixture at atmospheric or higher pressure comprising a carrier fluid in gaseous form, a source of oxygen and at least two precursors of the metal oxide coating, to cause deposition of the metal oxides on the substrate; with the proviso that at least one of the metal oxides is derived from nickel, tin, titanium, vanadium or zirconium.

2. A method as defined in claim 1 wherein the mixture of at least two oxides comprises a mixture of chromium oxide and tin oxide.

3. A method as defined in claim 1 or 2 wherein the substrate is comprised of ferrous metal.

4. A method as defined in claim 3 wherein the ferrous metal is cast iron.

5. A method as defined in claim 3 wherein the ferrous metal is stainless steel.

## Patentansprüche

1. Verfahren zum chemischen Dampfauftrag eines Überzugs aus gemischten Metalloxiden auf ein Substrat, ausgewählt aus Messing, Bronze, Aluminium, Gußeisen, Gußstahl und Edelstahl und Titan, bei Atmosphärendruck oder höherem Druck, um einen verschleißbeständigen Überzug auf dem Substrat herzustellen, dadurch **gekennzeichnet**, daß der Metalloxidüberzug ausgewählt aus der Gruppe, bestehend aus einem Gemisch von mindestens zwei Oxiden, ausgewählt aus der Gruppe, bestehend aus Oxiden von Aluminium, Cadmium, Chrom, Kobalt, Germanium, Indium, Iridium, Molybden, Nickel, Zinn, Tantal, Titan, Wolfram, Vanadium, Zink und Zirconium, ausgewählt ist, wobei das Verfahren die Behandlung des Substrats bei einer Temperatur über 400°C mit einem gasförmigen Gemisch bei Atmosphärendruck oder höherem Druck umfaßt, welches ein Trägerfluid in gasförmiger Form, eine Sauerstoffquelle und mindestens zwei Vorläufer des Metalloxidüberzugs umfaßt, um die Abscheidung der Metalloxide auf dem Substrat zu bewirken, mit der Maßgabe, daß mindestens eines der Metalloxide von Nickel, Zinn, Titan, Vanadium cder Zirconium abgeleitet ist.

2. Verfahren nach Anspruch 1, dadurch **gekennzeichnet,** daß das Gemisch mindestens zweier Oxide ein Gemisch aus Chromoxid und Zinnoxid umfaßt.

3. Verfahren nach Anspruch 1 oder 2, dadurch **gekennzeichnet,** daß das Substrat aus einem Eisenmetall ist.

4. Verfahren nach Anspruch 3, dadurch **gekennzeichnet,** daß das Eisenmetall Gußeisen ist.

5. Verfahren nach Anspruch 3, dadurch **gekennzeichnet**, daß das Eisenmetall Edelstahl ist.

## Revendications

1. Procédé pour le dépôt chimique en phase vapeur d'un revêtement mixte d'oxydes métalliques sur un substrat choisi entre le laiton, le bronze, l'aluminium, la fonte, et l'acier moulable et inoxydable ainsi que le titane à une pression égale ou supérieure à la pression atmosphérique pour former un revêtement résistant à l'usure sur le substrat, dans lequel le revêtement d'oxydes métalliques est choisi dans le groupe consistant en un mélange d'au moins deux oxydes choisis dans le groupe consistant en oxydes d'aluminium, de cadmium, de chrome, de cobalt, de germanium, d'indium, d'iridium, de molybdène, de nickel, d'étain, de tantale, de titane, de tungstène, de vanadium, de zinc et de zirconium, ledit procédé comprenant le traitement dudit substrat à une température supérieure à 400°C avec un mélange gazeux à une pression égale ou supérieure à la pression atmosphérique, comprenant un fluide servant de véhicule à l'état gazeux, une source d'oxygène et au moins deux précurseurs du revêtement d'oxydes métalliques, pour provoquer le dépôt des oxydes métalliques sur le substrat ; sous réserve qu'au moins un des oxydes métalliques soit dérivé du nickel, de l'étain, du titane, du vanadium ou du zirconium.

2. Procédé répondant à la définition suivant la revendication 1, dans lequel le mélange d'au moins deux oxydes comprend un mélange d'oxyde de chrome et d'oxyde d'étain.

3. Procédé répondant à la définition suivant la revendication 1 ou 2, dans lequel le substrat est constitué d'un métal ferreux.

4. Procédé répondant à la définition suivant la revendication 3, dans lequel le métal ferreux est la fonte.

5. Procédé répondant à la définition suivant la revendication 3, dans lequel le métal ferreux est l'acier inoxydable.
